Europäisches Patentamt

European Patent Office

Office européen des brevets

(19)

(11) Veröffentlichungsnummer: **0 008 363**
**B1**

(12)

# EUROPÄISCHE PATENTSCHRIFT

(45) Veröffentlichungstag der Patentschrift:
14.04.82

(21) Anmeldenummer: 79102483.9

(22) Anmeldetag: 16.07.79

(51) Int. Cl.³: **G 02 B 5/172**, G 01 R 15/07

(54) Verfahren zur Verbesserung des Signal-Rausch-Verhältnisses bei der Übertragung von polarisiertem Licht durch eine Lichtleitfaser und magnetooptischer Strommesswandler, bei dem das Verfahren angewandt wird.

(30) Priorität: 03.08.78 DE 2834098

(43) Veröffentlichungstag der Anmeldung:
05.03.80 Patentblatt 80/5

(45) Bekanntmachung des Hinweises auf die Patenterteilung:
14.04.82 Patentblatt 82/15

(84) Benannte Vertragsstaaten:
BE CH FR GB

(56) Entgegenhaltungen:
DE-A-2 338 252
DE-A1-2 451 124
DE-A1-2 556 693
DE-A1-2 624 692
DE-A1-2 616 920
DE-B2-2 316 732
US-A-3 484 152

(73) Patentinhaber: SIEMENS AKTIENGESELLSCHAFT Berlin
und München, Postfach 22 02 61, D-8000 München 22 (DE)

(72) Erfinder: Papp, Alfred, Dr., Winternitzstrasse 6,
D-8000 München 3 (DE)
Erfinder: Harms, Hauke, Annette-Kolb-Anger 11,
D-8000 München 83 (DE)

Verfahren zur Verbesserung des Signal/Rausch-Verhältnisses bei der Übertragung von polarisiertem Licht durch eine Lichtleitfaser, und magnetooptischer Strommesswandler, bei dem das Verfahren angewandt wird.

Die Erfindung betrifft ein Verfahren zur Verbesserung des Signal/Rausch-Verhältnisses bei der Übertragung von polarisiertem Licht durch eine Lichtleitfaser, die insbesondere als Messensor und Signalübertrager für magnetooptische Strommesswandler verwendet wird.

Es sind Messeinrichtungen für Ströme in Hochspannungsleitern und für grosse Wechselströme mit Gleichstromglied bekannt, bei denen ein Lichtstrahl über einen Polarisator, einen magnetooptischen Messfühler sowie einen Analysator einem Detektor zugeführt wird, dem eine Elektronik nachgeschaltet ist. Die Polarisationsebene des Lichtstrahls erhält in dem vom magnetischen Feld des zu messenden Stromes beeinflussten Messfühler eine der Grösse des Stromes entsprechende Drehung. In einer auf Erdpotential angeordneten Auswerteeinrichtung wird im Analysator die Grösse der Drehung in ein entsprechendes Intensitätssignal umgewandelt, das vom Fotodetektor erfasst werden kann. Das Ausgangssignal des Detektors wird in der Elektronik verarbeitet.

Aus der deutschen Patentschrift Nr. 21 30047 ist eine Messanordnung bekannt, bei der die Auswerteeinrichtung einen Analysator enthält, in dem das vom Messfühler kommende Licht in zwei Teillichtstrahlen aufgespalten wird, deren Polarisationsebenen senkrecht aufeinander stehen und die ihre Intensität mit dem Drehwinkel der Polarisationsebene des einfallenden Strahles gegenläufig ändern. Die beiden Teillichtstrahlen werden jeweils einem Detektor zugeführt, die vorzugsweise Halbleiterfotodioden sein können und denen ein Differenzverstärker nachgeschaltet ist. Die Differenzspannung dient als Mass für die Faraday-Drehung des Messignals und wird elektronisch durch eine der Lichtintensität proportionale Spannung dividiert. Mit diesem Verfahren können die Rauschanteile des Messignals eliminiert werden, die durch Intensitätsschwankungen des Lichtstrahles, vorzugsweise eines Laserstrahls, verursacht werden.

Ein weiteres bekanntes Verfahren [Rogers, in «Optical Methods for Measurement of Voltage and Current at High Voltage», A.I.M., Liège, Traitement des données, (1977), S. 6, Abschn. 3.2 (c), Intensity Distribution Noise] arbeitet mit einem modulierten Lichtstrahl, der über den Messfühler und einen Analysator einer einzigen Fotodiode zugeführt wird, deren Ausgangssignal in einer Elektronik verarbeitet wird. Der Detektor erfasst die Intensität des ankommenden Messsignals, das noch das überlagerte Modulationssignal enthält. Die Demodulation erfolgt in der nachgeschalteten Elektronik. Die Intensität wird sowohl durch die Faraday-Drehung im Messfühler als auch durch die Rauschanteile, nämlich die Intensitätsschwankungen der Strahlungsquelle sowie Intensitätsschwankungen der Strahlungsquelle sowie Intensitätsschwankungen, die durch mechanische Schwingungen der optischen Komponenten im Strahlengang verursacht werden, und ausserdem durch Empfindlichkeit der Fotodiode selbst, beeinflusst. Mit diesem Messverfahren können beide Intensitätskomponenten voneinander getrennt werden und der Rauschanteil am Messignal wird unterdrückt.

Rauschanteile, die eine Drehung der Polarisationsebene beinhalten, können mit den bislang bekannten Verfahren jedoch nicht eliminiert werden.

Es ist deshalb Aufgabe der vorliegenden Erfindung, bei der Übertragung von polarisiertem Licht durch eine Lichtleitfaser den Rauschpegel zu verringern und das Signal/Rausch-Verhältnis zu verbessern.

Diese Aufgabe wird dadurch gelöst, dass erfindungsgemäss zur Beseitigung des Polarisationsrauschens die Interferrenzeffekte in der Lichtleitfaser unterdrückt werden, indem die Endflächen der Lichtleitfaser abgeschrägt und/oder entspiegelt werden.

Folgende Überlegungen, die durch Laborversuche erhärtet sind, haben zu der erfindungsgemässen Lösung geführt. In einer Monomode-Lichtleitfaser, die z.B. als Messfühler und Übertragungsstrecke in einem magnetooptischen Strommesswandler dient, stehen die Endflächen senkrecht zur Faserachse. Wird linear polarisiertes Licht, z.B. von einer Helium-Neon-Laserlichtquelle, in die Faser eingekoppelt, so wird im Idealfall, wenn also keine Doppelbrechung und keine Erschütterungen vorhanden sind, Polarisationsgrad und -richtung erhalten bleiben. Durch Beeinflussung von ausserhalb der Lichtleitfaser, z.B. durch mechanische Erschütterungen, werden kleinste Lageveränderungen der Faserführung bewirkt, so dass eine Phasen- und Amplitudenmodulation entsteht, weil ein Teil des geführten Lichtes in den senkrecht zur ursprünglichen Richtung polarisierten Schwingungszustand überkoppelt. Sobald linear polarisiertes Licht in den beiden Hauptachsen der Monomode-Faser schwingt, führt diese Phasen- und Amplitudenmodulation am Faserausgang zu kleinen Änderungen des Polarisationszustandes, wodurch ein Rauschen im Messignal verursacht wird. Da das in der Lichtleitfaser geführte Laserlicht eine grosse Kohärenzlänge hat, kann das Polarisationsrauschen durch Interferenz zwischen dem direkten und an den Faserendflächen mehrfach reflektierten Strahlen verstärkt werden. Dieser Verstärkungseffekt kann durch Entspiegelung der Faserendstücke und/oder durch schräge Endflächen verhindert werden. Die Verkleinerung der Signalamplitude bei Entspiegelung der Faserendflächen ist durch den Wegfall der Interferenzeffekte zwischen durchgehenden und vielfach reflektierten Laserstrahlen bedingt.

Der Rauschpegel, dessen Höhe hauptsächlich durch mechanische Erschütterungen der Lichtleitfaser bestimmt wird, konnte durch die Beseitigung des Interferenzrauschens durch die Entspiegelung der Faserendflächen um den Faktor 10 verringert werden.

Als Messensor und Lichtleiter (Bereich 50 Hz ±30 Hz) wurde eine doppelbrechungsarme Quarzglaskern-Monomodefaser (Kerndurchmesser $d_K$=5 μm, Aussendurchmesser $d_A$=65 μm) von 12 m Länge verwendet.

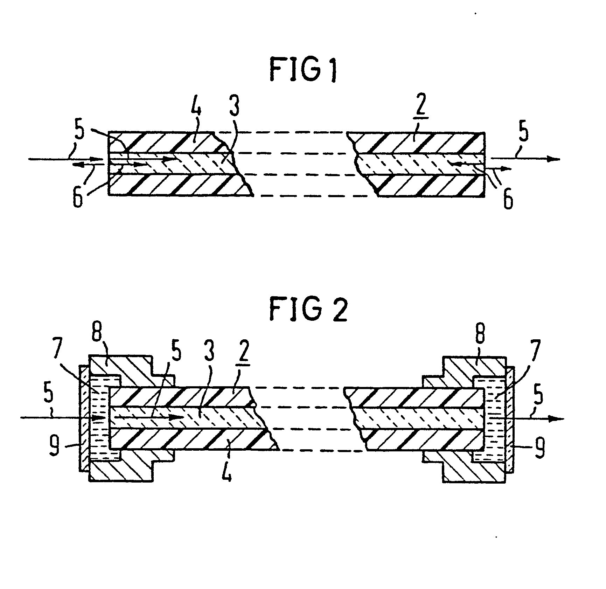

Weitere Einzelheiten der Erfindung sind den Fig. 1 und 2, welche in schematischer Darstellung die Wirkung einer Endflächenentspiegelung der Lichtleitfaser zeigen, zu entnehmen. Dabei zeigt die Fig. 1 eine Anordnung ohne Entspiegelung und Fig. 2 mit Entspiegelung.

In Fig. 1 ist mit dem Bezugszeichen 2 die aus Kern 3 und Mantel 4 bestehende Lichtleitfaser bezeichnet. Durch die Pfeile 5 wird der linear polarisierte Lichtstrahl dargestellt, der an den Faserenden reflektiert wird. Die mit den Pfeilen 6 bezeichneten Lichtstrahlen bewirken Interferrenzeffekte zwischen direktem und mehrfach reflektiertem Strahl und verschlechtern das Signal/Rausch-Verhältnis S/N.

Die in Fig. 2 gezeigte Anordnung enthält zur Unterdrückung der Interferrenzeffekte an den Endflächen der Lichtleitfaser 2 Entspiegelungsschichten in Form von mit Öl 7 als Immersionsflüssigkeit gefüllten Küvetten 8. Da keine Reflexionen an den Faserenden auftreten, sind auch keine Interferrenzeffekte vorhanden. Die an den Küvetten 8 angebrachten Endfenster 9 sind vorteilhafterweise zusätzlich entspiegelt.

Eine weitere Möglichkeit, Interferrenzeffekte auszuschalten, ist durch Abschrägen der Faserendflächen gegeben.

Die Erfindung ist anwendbar bei allen Anordnungen, in denen polarisiertes kohärentes Licht in einer Lichtleitfaser geführt wird. Insbesondere ist sie anwendbar für magnetooptische Strommessungen, bei denen polarisiertes Licht in einer vom Magnetfeld des zu messenden Stroms beeinflussten Lichtleitfaser eine von der Grösse des zu messenden Stromes abhängige Drehung seiner Polarisationsebene erfährt, und in einer auf Erdpotential angeordneten Auswerteeinrichtung in eine dem zu messenden Strom proportionale Grösse umgesetzt wird.

## Patentansprüche

1. Verfahren zur Verbesserung des Signal/Rausch-Verhältnisses bei der Übertragung von polarisiertem Licht durch eine Lichtleitfaser, die insbesondere als Messensor und Signalübertrager für magnetooptische Strommesswandler verwendet wird, dadurch gekennzeichnet, dass zur Beseitigung des Polarisationsdrehrauschens die Interferrenzeffekte in der Lichtleitfaser unterdrückt werden, indem die Endflächen der Lichtleitfaser abgeschrägt und/oder entspiegelt werden.

2. Verfahren nach Anspruch 1, dadurch gekennzeichnet, dass die Entspiegelung durch Immersionsflüssigkeiten, welche in Küvetten an den Endflächen der Lichtleitfaser angeordnet sind und nahezu den gleichen Brechungsindex wie die Lichtleitfaser aufweisen, vorgenommen wird.

3. Verfahren nach Anspruch 2, dadurch gekennzeichnet, dass die Endfenster der Küvetten zusätzlich entspiegelt werden.

4. Verfahren nach Anspruch 2 und 3, dadurch gekennzeichnet, dass als Immersionsflüssigkeit Öl verwendet wird.

5. Magnetooptischer Strommesswandler, bei dem polarisiertes Licht in einer vom Magnetfeld des zu messenden Stroms beeinflussten Lichtleitfaser eine von der Grösse des zu messenden Stromes abhängige Drehung seiner Polarisationsebene erfährt und in einer auf Erdpotential angeordneten Auswerteeinrichtung in eine dem zu messendem Strom proportionale Grösse umgesetzt wird, dadurch gekennzeichnet, dass die Lichtleitfaser zur Unterdrückung der Interferrenzeffekte an ihren senkrecht zur Faserachse stehenden Endflächen entspiegelt ist.

## Revendications

1. Procédé pour améliorer le rapport signal/bruit lors de la transmission d'une lumière polarisée dans une fibre optique utilisée en particulier comme détecteur de mesure et comme transmetteur de signaux pour des convertisseurs de mesure du courant, caractérisé par le fait que, pour supprimer le bruit de la rotation de polarisation, les effets interférentiels dans la fibre optique sont supprimés en biseautant les surfaces d'extrémité de la fibre optique ou en les rendant antiréfléchissantes.

2. Procédé selon la revendication 1, caractérisé par le fait que la propriété antiréfléchissante est obtenue à l'aide de liquides d'immersion, prévus dans des cuvettes disposées au niveau des surfaces d'extrémité de la fibre optique et qui ont un indice de réfraction sensiblement égal à celui de la fibre optique.

3. Procédé selon la revendication 2, caractérisé par le fait que les fenêtres d'extrémité des cuvettes sont également rendues antiréfléchissantes.

4. Procédé selon les revendications 2 et 3, caractérisé par le fait qu'on utilise de l'huile comme liquide d'immersion.

5. Convertisseur magnéto-optique de mesure du courant, du type dans lequel une lumière polarisée subit, dans une fibre optique soumise à l'action du champ magnétique du courant à mesurer, une rotation de son plan de polarisation, qui dépend du courant à mesurer et qui est transformée, par un dispositif d'évaluation mis au potentiel de terre, en une grandeur proportionnelle au courant à mesurer, caractérisé par le fait que, pour supprimer les effets d'interférence, les surfaces d'extrémité de la fibre optique qui sont perpendiculaires à l'axe de cette dernière sont rendues antiréfléchissantes.

## Claims

1. A process for improving the signal/noise ratio in the transmission of polarised light by means of a light-conducting fibre, in particular one which is used as a measuring sensor and signal transmitter for magneto-optical currentmeasuring transformers, characterised in that, in order to eliminate the polarisation rotational noise, the interference effects in the light-conducting fibre are suppressed by bevelling and/or rendering non-reflective the end faces of the light-conducting fibre.

2. A process as claimed in claim 1, characterised in that the end faces of the light-conducting fibre are rendered non-reflective by means of immersion liquids which are arranged in cells at the end faces of the light-conducting fibre and have substantially the same refractive index as the light-conducting fibre.

3. A process as claimed in claim 2, characterised in that the end windows of the cells are also rendered non-reflective.

4. A process as claimed in claims 2 and 3, characterised in that oil is used as the immersion liquid.

5. A magneto-optical current-measuring transformer in which, in a light-conducting fibre which is influenced by the magnetic field of the current to be measured, the polarisation plane of the polarised light is given a rotation which is dependent upon the magnitude of the current to be measured, and which is converted into a value which is proportional to the current to be measured in an analysing device which is arranged to be at earth potential, characterised in that, in order to suppress interference effects, the light-conducting fibre is rendered non-reflective at its end faces which are perpendicular to the fibre axis.

## FIG 1

## FIG 2